(19) Europäisches Patentamt
European Patent Office
Office européen des brevets

(11) **EP 3 571 089 B1**

(12) **EUROPÄISCHE PATENTSCHRIFT**

(45) Veröffentlichungstag und Bekanntmachung des Hinweises auf die Patenterteilung:
**26.05.2021 Patentblatt 2021/21**

(51) Int Cl.:
***B60M 1/28*** *(2006.01)*  *G01R 27/16* *(2006.01)*

(21) Anmeldenummer: **18704431.8**

(22) Anmeldetag: **23.01.2018**

(86) Internationale Anmeldenummer:
**PCT/EP2018/051550**

(87) Internationale Veröffentlichungsnummer:
**WO 2018/153592 (30.08.2018 Gazette 2018/35)**

(54) **VERFAHREN UND MESSEINRICHTUNG ZUR ERMITTLUNG VON FAHRDRAHTVERSCHLEISS IN EINER VERKEHRSTECHNISCHEN ANLAGE**

METHOD AND MEASUREMENT DEVICE FOR DETERMINING CONTACT WIRE WEAR IN A TRAFFIC SYSTEM

PROCÉDÉ ET DISPOSITIF DE MESURE POUR LA DÉTERMINATION DE L'USURE D'UNE CATÉNAIRE DANS UNE INSTALLATION TECHNIQUE DE TRANSPORT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.02.2017 DE 102017203174**

(43) Veröffentlichungstag der Anmeldung:
**27.11.2019 Patentblatt 2019/48**

(73) Patentinhaber: **Siemens Mobility GmbH
81739 München (DE)**

(72) Erfinder:
• DÖLLING, Andre
91056 Erlangen (DE)
• TERFLOTH, Sebastian
91080 Uttenreuth (DE)

(56) Entgegenhaltungen:
JP-A- 2003 329 431    SU-A1- 685 526
SU-A1- 1 311 958

**Beschreibung**

Die Erfindung betrifft ein Verfahren zur Ermittlung von Fahrdrahtverschleiß in einer verkehrstechnischen Anlage, bei dem ein für den Verschleiß repräsentativer Ist-Querschnitt des Fahrdrahts ermittelt wird, wobei zur Ermittlung des Ist-Querschnitts in einem Abschnitt des Fahrdrahtes ein Ist-Widerstand in dem Abschnitt bestimmt wird.

Die Erfindung betrifft weiterhin eine Messeinrichtung zur Ermittlung von Fahrdrahtverschleiß in einer verkehrstechnischen Anlage, wobei die Messeinrichtung zum Ermitteln eines für den Verschleiß repräsentativen Ist-Querschnitts des Fahrdrahts ausgebildet ist, wobei die Messeinrichtung zur Ermittlung des repräsentativen Ist-Querschnitts des Fahrdrahtes zur Ermittlung eines Ist-Widerstandes von einem Abschnitt des Fahrdrahtes ausgebildet ist.

Fahrleitungen elektrischer Bahnen, insbesondere Fahrdrähte oder Stromschienen, unterliegen durch den Kontakt mit einem an den Fahrzeugen angeordneten Stromabnehmer einem Verschleiß. Unter elektrischen Bahnen einer verkehrstechnischen Anlage werden hier insbesondere beispielsweise Eisenbahnfahrzeuge wie Lokomotiven und Züge, Straßenbahnen und U-Bahnen, aber auch elektrisch betriebene Busse oder LKWs verstanden.

Ausgehend vom Querschnitt eines neuen Fahrdrahts darf der Fahrdraht im Betrieb der verkehrstechnischen Anlage nur bis zu einem gewissen Restquerschnitt abgefahren werden, bevor er ausgetauscht werden muss. Ein definierter Mindestquerschnitt des Fahrdrahts darf aus Sicherheitsgründen nicht unterschritten werden, weil sonst die mechanische und elektrische Belastbarkeit des Fahrdrahts überschritten werden könnte. Dieser Mindestquerschnitt ist beispielsweise für Straßen- und Stadtbahnen auf 60 % des Ausgangsquerschnitts begrenzt. Bei einigen Unternehmen ist der Mindestquerschnitt sogar auf beispielsweise 80 % des Ausgangsquerschnitts begrenzt. Ähnliche Vorgaben bestehen für Stromschienensysteme, wo ein Stromabnehmer oder Schleifschuh eines Fahrzeugs anstatt einem Fahrdraht eine Stromschiene zur elektrischen Energieversorgung beschleift. Auch hier sind vorgegebene Verschleißgrenzmaße einzuhalten. Wenn im Folgenden und in den Patentansprüchen von einem Fahrdraht gesprochen wird, ist darunter neben einem Fahrdraht auch eine Stromschiene oder andere Fahrleitungen, die während der Fahrt von einem Stromabnehmer beschliffen werden, zu verstehen.

Insbesondere die unter mechanischer Zugspannung befindlichen Fahrdrähte werden mit zunehmendem Verschleiß mechanisch und thermisch stärker beansprucht. Die Betreiber von verkehrstechnischen Anlagen müssen daher regelmäßig Aufzeichnungen bezüglich des Verschleißes der Fahrdrähte anfertigen, die idealerweise für das gesamte Streckennetz möglichst lückenlos vorliegen sollen. Abhängig vom ermittelten Verschleiß kann eine weitere Nutzung erfolgen oder eine Instandsetzung mit einem kompletten oder partiellen Austausch des Fahrdrahts ist einzuplanen.

Bei bekannten Verfahren zur Ermittlung von Fahrdrahtverschleiß wird dieser mit Hilfe des aktuellen Ist-Querschnitts des Fahrdrahtes ermittelt. Der Ist-Querschnitt wird beispielsweise durch eine Messung einer Restdicke des Fahrdrahts oder einer Schleifspiegelbreite des Fahrdrahts ermittelt. Unter Annahme einer ebenen Kontaktfläche kann der Restquerschnitt des Fahrdrahts aus der Schleifspiegelbreite rechnerisch bestimmt oder aus Tabellen abgelesen werden. Bei Unterschreitung eines vorgegebenen Grenzwerts muss der betroffene Fahrdrahtabschnitt ausgetauscht werden.

Die Messung kann manuell durch Bügelmessschrauben, Messschieber oder ähnlichen Messwerkzeugen geschehen. Mit der manuellen Messung sind allerdings nur einzelne, punktuelle und nur schwerlich kontinuierliche Messungen möglich. Die Sicherstellung des Mindestquerschnitts in der gesamten verkehrstechnischen Anlage basiert in diesem Fall daher auf der Erfahrung des Betreibers, der die kritischen Punkte im Streckennetz kennt. Die manuelle Messmethode ist beispielsweise im Nahverkehrsbereich üblich.

Für den Fernverkehr mit sehr ausgedehnten Fahrleitungsanlagen wurden andere Messverfahren entwickelt, die flächendeckendere Messergebnisse liefern. Beispielsweise wird der Verschleiß berührungslos durch Kameras und/oder Lasermesseinrichtungen ermittelt, die eine zeitlich eng wiederholte Messung und Berechnung des Querschnitts erlauben. Es sind Systeme bekannt, die auch auf Hochgeschwindigkeitsfahrzeugen Messwerte im Abstand von wenigen Zentimetern liefern können. Die Messwertdichte kann so hoch sein, dass von einer kontinuierlichen Messung des Querschnitts gesprochen werden kann. Allerdings sind diese Systeme sehr kostenintensiv, so dass das Kostennutzungsverhältnis, insbesondere für kleine Verkehrsbetriebe, ungünstig sein kann.

Bekannt ist hier beispielsweise ein Wire Wear Monitoring System WWS von der Fa. Fraunhofer IPM. Andere Systeme sind beispielsweise in verschiedenen Fachartikeln beschrieben, wie beispielsweise "Neues System zur Messung des Fahrdrahtverschleißes" (Deutzer, Fiebelkorn, Pirkl, Winkler, Deutzer; Der Nahverkehr 4/2013, Seiten 40 bis 43; "Inspektion von Fahrdrahtlage und -stärke bei beliebiger Geschwindigkeit" Sarnes, Elektrische Bahnen eb 99, 12/2001, Seiten 490 bis 495; "Automatische optische Inspektion von Oberleitungen", Richter, Schneider, Elektrische Bahnen eb 99, 1-2/2001, Seiten 90 bis 100) .

Die SU 685 526 A1 offenbart ein Messgerät zur Messung der Fahrdrahtabnutzung.

Der Erfindung liegt die Aufgabe zugrunde, ein Verfahren und eine Vorrichtung der oben genannten Art bereitzustellen, die eine kostengünstigere und trotzdem flächendeckende Ermittlung des Fahrdrahtverschleißes ermöglicht.

Das erfindungsgemäße Verfahren löst diese Aufgabe dadurch, dass die Position von dem Abschnitt des Fahrdrahts erfasst wird und der Verschleiß an einer Vielzahl von Positionen der verkehrstechnischen Anlage ermittelt, abgespeichert und der flächendeckende Verschleiß des Fahrdrahts in der verkehrstechnischen Anlage graphisch dargestellt wird.

Die erfindungsgemäße Messeinrichtung der eingangs genannten Art löst die Aufgabe dadurch, dass dass die Messeinrichtung mit einer Positionsbestimmungseinrichtung zur Bestimmung der aktuellen Position eines Fahrzeugs verbunden ist, und die Messeinrichtung wenigstens eine Stromquelle, die zur Erzeugung eines in den Fahrdraht einspeisbaren Messstroms ausgebildet ist, und wenigstens eine Spannungsmesseinrichtung, die zur Ermittlung eines Spannungsabfalls in dem Abschnitt des Fahrdrahtes ausgebildet ist, und wenigstens eine Speichereinheit, die zur Ablegung der Messwerte der Spannungsmesseinrichtung mit der durch die Positionsbestimmungseinrichtung ermittelten, aktuellen Position des Fahrzeugs ausgebildet ist, aufweist.

Es wird erfindungsgemäß ein lokaler Ist-Querschnitt des Fahrdrahts aus dem messtechnisch erfassten zugehörigen lokalen Ist-Widerstand bestimmt.

Die erfindungsgemäße Lösung hat den Vorteil, dass der Ist-Widerstand für einen Abschnitt des Fahrdrahts auf einfache Weise und dadurch kostengünstig ermittelt werden kann. Wenn die Erfindung auf Fahrzeugen innerhalb der verkehrstechnischen Anlage ausgeführt wird, kann eine kontinuierliche und damit flächendeckende Ermittlung des Fahrdrahtverschleißes in der verkehrstechnischen Anlage erfolgen.

Im Gegensatz zu den bekannten oben genannten Messverfahren aus dem Stand der Technik ist die erfindungsgemäße Ermittlung des Fahrdrahtverschleißes kostengünstiger, da beispielsweise keine Kamera-, Laser- und/oder Beleuchtungstechnik erforderlich ist. Vorteilhafterweise ist das erfindungsgemäße Verfahren anders als die optischen Verfahren aus dem Stand der Technik unempfindlich gegen externe Sonneneinstrahlung, Regen oder Schnee und benötigt keine Mindesthelligkeit, die beispielsweise durch zusätzliche Beleuchtung sichergestellt werden müsste.

Bei der aus dem Stand der Technik bekannten Messung von Resthöhen oder Schleifspiegelbreiten am Fahrdraht wird der Ist-Querschnitt unter Annahme einer ebenen, vollständig beschliffenen Kontaktfläche berechnet. Ist die Kontaktfläche aber in Wirklichkeit nicht eben, beispielsweise durch einseitige Abfahrung nach einer Lageänderung des Fahrdrahts oder durch rund abgefahrene Fahrdrähte, wird der Restquerschnitt größer berechnet, als er tatsächlich ist. Bei der erfindungsgemäßen Ermittlung des elektrischen Ist-Widerstands und der daraus auf Basis der bekannten Länge des Abschnitts des Fahrdrahts berechenbaren Querschnitts spielt die Form der Kontaktfläche keine Rolle. In der Form der Kontaktfläche begründete Messfehler sind somit ausgeschlossen.

Die Erfindung kann durch vorteilhafte Ausgestaltungen weiter entwickelt werden, die im Folgenden beschrieben sind.

So kann der Ist-Widerstand, insbesondere temperaturkorrigiert, mit einem vorbestimmten Soll-Widerstand verglichen werden. Dies hat den Vorteil, dass das Überschreiten einer zulässigen Verschleißgrenze auf einfache Weise bestimmt werden kann. Der vorbestimmte Sollwiderstand kann beispielsweise für den Widerstand stehen, der einem neuen unbenutzten Fahrdraht entspricht. Alternativ kann der Soll-Widerstand aber auch einem an der zugelassenen Verschleißgrenze befindlichen Fahrdraht entsprechen.

Alternativ kann auch direkt der ermittelte Ist-Querschnitt mit einem vorbestimmten Soll-Querschnitt verglichen werden. Dies hat den Vorteil, dass häufig der Soll-Querschnitt bereits vorgegeben ist und das Verfahren einfach anwendbar ist. Soll-Querschnitt kann beispielsweise entweder der Nennwert oder ein Verschleiß-Grenzwert sein, ähnlich wie beim Soll- Widerstand. Eine Temperaturkorrektur findet auch beim Ist-Querschnitt statt.

Um das erfindungsgemäße Verfahren auch in solchen Abschnitten des Fahrdrahts anwenden zu können, die widerstandsverändernde Konstruktionselemente wie beispielsweise Klemmen, Stromverbinder, Seitenhalter, Streckentrenner etc. aufweisen, kann der Ist-Widerstand oder Ist-Querschnitt mit einem in Abhängigkeit vom Abschnitt des Fahrdrahts aus mehreren Soll-Widerständen oder Soll-Querschnitten ausgewählten Soll- Widerstand oder Soll-Querschnitt verglichen werden. Es wird dann zwischen wenigstens zwei Arten von Abschnitten unterschieden: Solche mit einem Konstruktionselement und solche ohne. Die Konstruktionselemente verkleinern nämlich beispielsweise den Ist-Widerstand vom Abschnitt des Fahrdrahts, was durch einen alternativen Soll-Widerstand berücksichtigt wird. Der Ist-Querschnitt ist entsprechend vergrößert. Der Soll-Widerstand, der Soll-Querschnitt, die Soll-Widerstände oder Soll-Querschnitte können für unterschiedliche Abschnitte des Fahrdrahts in einer oder mehreren Referenzmessungen auf besonders einfache Weise ermittelt werden.

Um die ermittelten Fahrdrahtverschleißwerte innerhalb der verkehrstechnischen Anlage positionsgenau zuweisen zu können, wird die Position von dem Abschnitt des Fahrdrahts erfasst. So kann die Position des Fahrdrahts zum zugehörigen Messwert und damit Verschleißgrad zugeordnet werden. Beispielsweise kann hierfür eine Ortsbestimmungseinrichtung, wie beispielsweise ein GPS-System oder eine Odometrieeinrichtung eines Fahrzeugs, genutzt werden. Die Odometrieeinrichtung, die in einer sehr einfachen Weise durch eine Wegmessung, beispielsweise mittels Laufrad oder Wegsignalgeber, mit Nullabgleich an markanten Punkten ausgebildet sein kann, kennt stets die Position des Fahrzeugs. Markante Punkte können sowohl im Fahrweg, wie beispielsweise Balisen, sein, oder auch in der Oberleitungsanlage, wie beispielsweise Seitenhalter oder Klemmen, die an bekannten Positionen angeordnet sind.

Im erfindungsgemäßen Verfahrens wird der Verschleiß an einer Vielzahl von Positionen der verkehrstechnischen Anlage ermittelt, abgespeichert und graphisch dargestellt. Dabei wird eine flächendeckende Verschleißermittlung der Fahrdrähte in einer verkehrstechnischen Anlage ermittelt und für einen Bediener besonders einfach erfassbar aufbereitet.

Für eine konstruktiv einfache und damit kostengünstige Durchführung des erfindungsgemäßen Verfahrens kann zur Ermittlung des Ist-Widerstands ein Messstrom in den Abschnitt des Fahrdrahts eingeleitet und ein durch den Messstrom und den Ist-Widerstand bedingter Spannungsabfall im Abschnitt des Fahrdrahts ermittelt werden.

Ferner kann der Ist-Widerstand potentialgetrennt zum Fahrdraht ermittelt werden. Dies hat den Vorteil, dass auch eine Messung bei eingeschalteter Fahrleitung erfolgen kann. Vorzugsweise wird die Ermittlung des Fahrdrahtverschleißes durchgeführt, wenn kein Stromfluss im Speiseabschnitt des Fahrdrahts erfolgt, da so ein unverfälschter Spannungsabfall gemessen und der Fahrdrahtverschleiß besonders einfach ermittelt werden kann. Soll der Fahrdrahtverschleiß alternativ bei einem Stromfluss im Fahrdraht durch angetriebene Fahrzeuge im Speiseabschnitt ermittelt werden, müsste der von den Fahrzeugen verbrauchte Strom zur Korrekturrechnung erfasst werden. Um Serviceeinsätze und den Austausch von verschlissenem Fahrdraht besonders gut koordinieren zu können, kann der Verschleiß für den gleichen Abschnitt des Fahrdrahts zu verschiedenen Zeitpunkten ermittelt und daraus ein Verschleiß des Abschnitts in der Zukunft prognostiziert werden. Die Vorausberechnung kann beispielsweise rechnergestützt durch geeignete Simulationen ermittelt werden. So ist eine langfristige Planung von Wartungsarbeiten für die verkehrstechnische Anlage besonders gut möglich.

Weiterhin kann der Ist-Widerstand während einer Fahrt entlang des Fahrdrahts ermittelt werden. Dies hat den Vorteil, dass eine kontinuierliche Messwerterfassung auf einfache Weise möglich ist.

Die erfindungsgemäße Messeinrichtung weist wenigstens eine Stromquelle, die zur Erzeugung eines in den Fahrdraht einspeisbaren Messstroms ausgebildet ist, und wenigstens eine Spannungsmesseinrichtung, die zur Ermittlung eines Spannungsabfalls in dem Abschnitt des Fahrdrahts ausgebildet ist, auf. Dies hat den Vorteil, dass so eine besonders einfache und kostengünstige Ausführung der Messeinrichtung möglich ist.

Ferner kann die Messeinrichtung potentialgetrennt zur Fahrleitung ausgebildet sein. Dies hat den oben bereits beschriebenen Vorteil, dass eine Messung bei eingeschalteter Fahrleitung möglich ist.

Schließlich betrifft die Erfindung auch noch ein Fahrzeug mit einem Kontaktmittel zum Kontaktieren eines Fahrdrahts einer verkehrstechnischen Anlage, wobei das Fahrzeug zum Fahren auf einem entlang des Fahrdrahts verlaufenden Fahrwegs ausgebildet ist. Um eine kostengünstige und trotzdem flächendeckende Ermittlung des Fahrdrahtverschleißes in der verkehrstechnischen Anlage zu ermitteln, ist das Fahrzeug erfindungsgemäß mit wenigstens einer Messeinrichtung nach einer der oben genannten Ausführungsformen ausgestaltet, die mit dem Kontaktmittel verbunden ist.

In einer besonders vorteilhaften Ausgestaltung kann das Fahrzeug mit wenigstens einer Erkennungseinrichtung zur Erkennung von widerstandsverändernden Konstruktionselementen an der Fahrleitung ausgebildet sein. Diese Konstruktionselemente sind beispielsweise Klemmen, Stromverbinder, Seitenhalter oder Streckentrenner, die jeweils den Ist-Widerstand im Abschnitt des Fahrdrahts verändern, insbesondere verkleinern, gegenüber Abschnitten ohne solche Konstruktionselemente. Durch die Erkennung der Konstruktionselemente kann der ermittelte Ist-Widerstand entsprechend anders bewertet und beispielsweise mit einem entsprechenden anderen Soll-Widerstand verglichen werden. So kann auch beispielsweise der Fahrdrahtverschleiß unter Klemmen auf zuverlässige Weise ermittelt werden, der üblicherweise größer und daher relevanter ist.

Im Folgenden wird die Erfindung mit Bezug auf die in den Figuren dargestellte beispielhafte Ausführungsform erläutert.

Es zeigen:

Figur 1 eine schematische Darstellung einer beispielhaften Ausführungsform eines erfindungsgemäßen Fahrzeugs mit einer erfindungsgemäßen Messeinrichtung zur Ermittlung von Fahrdrahtverschleiß;

Figur 2 eine schematische Darstellung der erfindungsgemäßen Messeinrichtung des Fahrzeugs aus Figur 1.

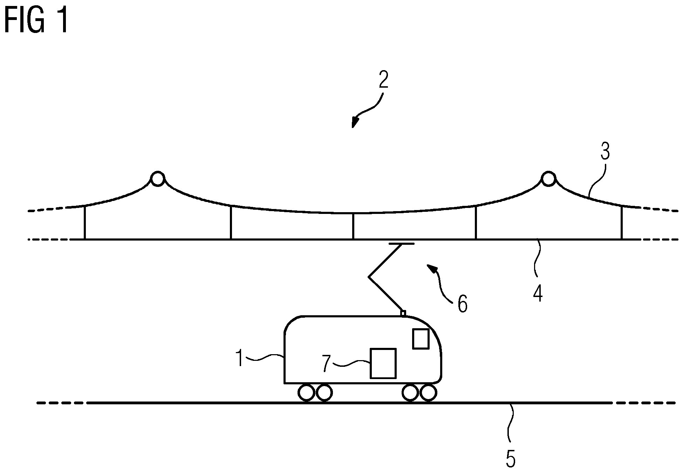

In Figur 1 ist eine beispielhafte Ausführungsform eines erfindungsgemäßen Fahrzeugs 1 schematisch dargestellt, das beispielsweise ein Messfahrzeug oder Instandhaltungsfahrzeug ist. Das Fahrzeug 1 ist Teil einer verkehrstechnischen Anlage 2, die weiterhin eine Fahrleitung 3 mit einem Fahrdraht 4 und einen Fahrweg 5, beispielsweise in Form von Schienen, aufweist.

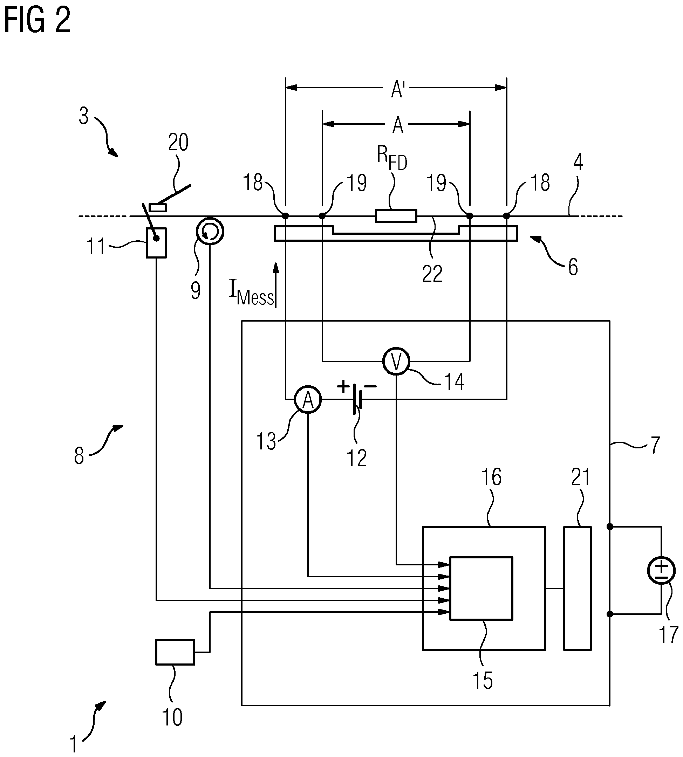

Das Fahrzeug 1 ist hier in der beispielhaften Ausführungsform der Figuren 1 und 2 als Schienenfahrzeug und zum Fahren entlang des Fahrwegs 5 ausgebildet. Das Fahrzeug weist ein Kontaktmittel 6 in Form eines Stromabnehmers und eine mit dem Kontaktmittel 6 verbundene Messeinrichtung 7 auf. Das Kontaktmittel 6 ist hier insbesondere als ein Messstromabnehmer ausgebildet, der den Fahrdraht 4 während der Fahrt des Fahrzeugs 1 kontaktiert, ohne dass Traktionsenergie aus dem Fahrdraht 4 gezogen wird. Das Kontaktmittel 6 wird dafür in bekannter Weise in schleifenden Kontakt mit dem Fahrdraht 4 gebracht. Die Messeinrichtung 7 ist erfindungsgemäß zur Ermittlung eines Fahrdrahtverschleißes des Fahrdrahts 4 in der verkehrstechnischen Anlage 2 ausgebildet und wird im Folgenden mit Bezug auf die beispielhafte Ausführungsform in Figur 2 erläutert.

Das Fahrzeug 1 umfasst weiterhin, wie in Figur 2 dargestellt, eine Positionsbestimmungseinrichtung 8, die in der beispielhaften Ausführungsform in Figur 2 einen Wegsignalgeber 9, einen GPS-Signalgeber 10 und eine Erkennungseinrichtung 11 aufweist. Alternativ kann die Positionsbestimmungseinrichtung 8 aber auch nur einen dieser Sensorkomponenten aufweisen. Die Positionsbestimmungseinrichtung 8 und deren einzelne Komponenten sind mit der Messeinrichtung 7 verbunden.

Die Messeinrichtung 7 weist in der beispielhaften Ausführungform in Figur 2 eine Stromquelle 12, eine Strommesseinrichtung 13, eine Spannungsmesseinrichtung 14 und eine mit einer Signalschnittstelle 15 ausgestattete Speichereinheit 16 auf.

Das Fahrzeug 1 umfasst weiterhin eine vom Fahrdraht 4 potentialgetrennte Energieversorgungseinrichtung 17, die die Messeinrichtung 7 mit Energie versorgt.

Die Messeinrichtung 7 ist an vier Punkten mit dem Kontaktmittel 6 verbunden, das sich in Schleifkontakt mit dem Fahrdraht 4 befindet. Dabei ist die Stromquelle 12 mit zwei äußeren Kontaktpunkten 18 und die Spannungsmesseinrichtung 14 mit zwei inneren Kontaktpunkten 19 verbunden. Die inneren Kontaktpunkte 19 sind in einem Abstand A zueinander angeordnet, die äußeren Kontaktpunkte 18 in einem Abstand A', der größer als der Abstand A ist.

Die Positionsbestimmungseinrichtung 8 des Fahrzeugs 1 ist in einer an sich bekannten Weise so ausgebildet, eine aktuelle Position des Fahrzeugs 1 zu bestimmen. Der GPS-Signalgeber 10 führt dies in bekannter Weise durch Ermittlung eines GPS-Signals durch. Der Wegsignalgeber 9, der in Figur 2 beispielhaft als ein Laufrad dargestellt ist, ermittelt die Position durch Messung des vom Fahrzeug 1 zurückgelegten Wegs und einem Nullabgleich an bekannten Referenzpunkten, wie beispielsweise am Fahrweg 5 angeordneten Balisen (nicht dargestellt). Die Erkennungseinrichtung 11 ist zur Erkennung von Konstruktionselementen 20 entlang des Fahrdrahts 4 ausgebildet. Diese Konstruktionselemente 20 können Seitenhalter, Klemmen, Stromverbinder, Streckentrenner oder ähnliches sein, die einerseits als Referenzpunkte des Wegsignalgebers 9 genutzt werden können und/oder auch für die erfindungsgemäße Ermittlung des Fahrdrahtverschleißes benutzt werden, wie im Folgenden noch genauer erläutert wird.

Die Speichereinheit 16 ist zur Speicherung von Messwerten ausgebildet, die die Signalschnittstelle 15 empfängt. Die Signalschnittstelle 15 umfasst Messeingänge für die Spannungsmesseinrichtung 14, die Strommesseinrichtung 13, den Wegsignalgeber 9, den GPS-Signalgeber 10 und die Erkennungseinrichtung 11.

Die Messeinrichtung 7 umfasst ferner eine mit der Speichereinheit 16 verbundene Auswerteeinrichtung 21, die zur Ermittlung des Fahrdrahtverschleißes ausgebildet ist. Die Auswerteeinrichtung 21 ist in der beispielhaften Ausführungsform in Figur 2 Teil der Messeinrichtung 7. Alternativ kann die Auswerteeinrichtung 21 aber auch außerhalb der Messeinrichtung 7, beispielsweise in einer Zentrale der verkehrstechnischen Anlage 2 extern vom Fahrzeug 1 angeordnet sein.

Im Folgenden wird das erfindungsgemäße Verfahren zur Ermittlung von Fahrdrahtverschleiß in der verkehrstechnischen Anlage 2 mit der erfindungsgemäßen Messeinrichtung 7 beschrieben.

Mit Hilfe der durch das Fahrzeug 1 fahrbaren Messeinrichtung 7 wird über die äußeren Kontaktpunkte 18 ein Messstrom $I_{Mess}$, der von der Stromquelle 12 bereitgestellt wird, in den Fahrdraht 4 eingespeist. Die Größe des Messstroms $I_{Mess}$ wird durch die Strommesseinrichtung 13 erfasst und über die Signalschnittstelle 15 an die Speichereinheit 16 weitergeleitet. Gleichzeitig misst die Spannungsmesseinrichtung 14 den Spannungsabfall zwischen den inneren Kontaktpunkten 19. Die gemessene Spannungsgröße wird von der Spannungsmesseinrichtung 14 über die Signalschnittstelle 15 an die Speichereinheit 16 weitergegeben.

Die Auswerteeinrichtung 21 berechnet aus dem von der Spannungsmesseinrichtung 14 ermittelten Spannungsabfall und dem von der Strommesseinrichtung 13 ermittelten Messstrom $I_{Mess}$ den Ist-Widerstand in einem Abschnitt 22 des Fahrdrahts 4, der sich bei der Messung zwischen den inneren Kontaktpunkten 19 an dem Kontaktmittel 6 befand. Der Abstand A zwischen den inneren Kontaktpunkten 19 beträgt beispielsweise zwischen 0,2 m und 1 m. Die Auswerteeinrichtung 22 ermittelt anschließend aus dem Ist-Widerstand und der spezifischen Leitfähigkeit p des Fahrdrahtmaterials und dem bekannten Abstand A einen durchschnittlichen Ist-Querschnitt des Fahrdrahts 4 in diesem Abschnitt 22. Anschließend wird dieser Ist-Widerstand oder Ist-Querschnitt temperaturkorrigiert und mit einem Soll- Widerstand oder Soll-Querschnitt verglichen. Der Soll- Widerstand repräsentiert beispielsweise den Widerstand eines Abschnitts 22 des Fahrdrahts 4 im Neuzustand. Aus diesem Vergleich ermittelt die Auswerteeinrichtung 21 einen Ist-Querschnitt. Abschließend wird immer ein Verschleiß des Fahrdrahts 4 im Abschnitt 22 ermittelt. Es gilt die Formel:

$$R = (\rho(Rho) * A) / Q,$$

wobei

R der Widerstand,
p(Rho) die spezifische Leitfähigkeit (temperaturabhängig) und Q der Querschnitt sind.

Der Verschleiß kann alternativ auch direkt aus dem Ist-Widerstand geschlossen werden.

Die erfindungsgemäße Messeinrichtung 7 kann beispielsweise auch auf vorhandenen Instandhaltungsfahrzeugen einer verkehrstechnischen Anlage 2 nachgerüstet werden. In diesem Fall werden die inneren und äußeren Kontaktpunkte 18, 19 auf ein vorhandenes Kontaktmittel 6 aufgeklemmt.

In der Speichereinheit 16 werden die Messwerte der Strommesseinrichtung 13 und der Spannungsmesseinrichtung 14 mit der durch die Positionsbestimmungseinrichtung 8 ermittelten aktuellen Position des Fahrzeugs 1 abgelegt. Dadurch ist eine kontinuierliche Verschleißermittlung des Fahrdrahts 4 entlang des Fahrwegs 5 möglich.

Die erfindungsgemäße Messeinrichtung 7 kann aber auch anstatt auf vorhandenen Instandhaltungsfahrzeugen auf einfachen Fahrzeugen ohne Antrieb, wie beispielsweise Schienentransportwagen, sogenannten Loren, angeordnet werden und dann manuell oder mit Hilfe von einem anderen angetriebenen Fahrzeug durch die verkehrstechnische Anlage 2 gefahren werden.

Durch die erfindungsgemäße permanente, automatisierte Messwerterfassung und Messwertaufzeichnung durch die Speichereinheit 6 in dem sich bewegenden Fahrzeug 1 können große Streckenabschnitte der verkehrstechnischen Anlage 2 befahren und vermessen werden. Dabei kann der Verschleiß des Fahrdrahts 4 kontinuierlich ermittelt werden.

Durch die Erkennungseinrichtung 11 werden Konstruktionselemente 20 ermittelt. Diese Konstruktionselemente 20 haben eine widerstandsverändernde Wirkung auf den Abschnitt 22 des Fahrdrahts 4, der durch die Messeinrichtung 7 vermessen wird, weil der Ist-Querschnitt größer ist. Beispielsweise ist an Klemmen der Gesamtwiderstand des Fahrdrahts 4 durch die Materialverstärkung des Konstruktionselements 20 kleiner als in einem Abschnitt ohne Klemme. Durch Referenzmessungen wird erfindungsgemäß daher ein anderer Soll-Widerstand oder Soll-Querschnitt für Abschnitte 22 mit Konstruktionselementen 20 ermittelt. Dieser ist unterschiedlich zu einem Soll- Widerstand oder Soll-Querschnitt in Abschnitten 22 ohne Konstruktionselemente 20. Durch die Erkennung eines vorhandenen Konstruktionselements 20 durch die Erkennungseinrichtung 11 kann bei dem erfindungsgemäßen Verfahren der entsprechende Soll-Widerstand oder Soll-Querschnitt ausgewählt und für die Verschleißermittlung in diesem Abschnitt verwendet werden.

**Patentansprüche**

1. Verfahren zur Ermittlung von Fahrdrahtverschleiß in einer verkehrstechnischen Anlage (2), bei dem ein für den Verschleiß repräsentativer Ist-Querschnitt des Fahrdrahtes (4) ermittelt wird, wobei zur Ermittlung des Ist-Querschnitts in einem Abschnitt des Fahrdrahtes (4) ein Ist-Widerstand in dem Abschnitt (22) bestimmt wird **dadurch gekennzeichnet, dass** die Position von dem Abschnitt (22) des Fahrdrahts (4) erfasst wird und der Verschleiß an einer Vielzahl von Positionen der verkehrstechnischen Anlage (2) ermittelt, abgespeichert und der flächendeckende Verschleiß des Fahrdrahts (4) in der verkehrstechnischen Anlage graphisch dargestellt wird.

2. Verfahren nach Anspruch 1, **dadurch gekennzeichnet, dass** der Ist-Widerstand, insbesondere temperaturkorrigiert, mit einem vorbestimmten Soll-Widerstand verglichen wird.

3. Verfahren nach Anspruch 1 oder 2, **dadurch gekennzeichnet, dass** der Ist-Querschnitt, insbesondere temperaturkorrigiert, mit einem vorbestimmten Soll-Querschnitt verglichen wird.

4. Verfahren nach Anspruch 2 oder 3, **dadurch gekennzeichnet, dass** der Ist-Widerstand oder der Ist-Querschnitt mit einem in Abhängigkeit vom Abschnitt (22) des Fahrdrahts (4) aus mehreren Soll-Widerständen oder Soll-Querschnitten ausgewählten Soll- Widerstand oder Soll-Querschnitt verglichen wird.

5. Verfahren nach einem der oben genannten Ansprüche 2 bis 4, **dadurch gekennzeichnet, dass** der Soll-Widerstand, der Soll-Querschnitt, die Soll-Widerstände oder die Soll-Querschnitte in einer oder mehreren Referenzmessungen ermittelt werden.

6. Verfahren nach einem der oben genannten Ansprüche, **dadurch gekennzeichnet, dass** zur Ermittlung des Ist-Widerstandes ein Messstrom in den Abschnitt des Fahrdrahts (4) eingeleitet und ein durch den Messtrom und den Ist-Widerstand bedingter Spannungsabfall im Abschnitt (22) des Fahrdrahts (4) ermittelt wird.

7. Verfahren nach einem der oben genannten Ansprüche, **dadurch gekennzeichnet, dass** der Ist-Widerstand potentialgetrennt zum Fahrdraht (4) ermittelt wird.

8. Verfahren nach einem der oben genannten Ansprüche, **dadurch gekennzeichnet, dass** der Verschleiß für den gleichen Abschnitt des Fahrdrahts (4) zu verschiedenen Zeitpunkten ermittelt und daraus ein Verschleiß des Abschnitts in der Zukunft prognostiziert wird.

9. Verfahren nach einem der oben genannten Ansprüche,
**dadurch gekennzeichnet, dass**
der Ist-Widerstand während einer Fahrt entlang des Fahrdrahts (4) ermittelt wird.

10. Messeinrichtung (7) zur Ermittlung von Fahrdrahtverschleiß in einer verkehrstechnischen Anlage (2), wobei die Messeinrichtung (7) zum Ermitteln eines für den Verschleiß repräsentativen Ist-Querschnitts des Fahrdrahtes (4) ausgebildet ist, wobei die Messeinrichtung (7) zur Ermittlung des repräsentativen Ist-Querschnitts des Fahrdrahtes (4) zur Ermittlung eines Ist-Widerstandes von einem Abschnitt des Fahrdrahtes (4) ausgebildet ist
**dadurch gekennzeichnet, dass**
die Messeinrichtung (7) mit einer Positionsbestimmungseinrichtung (8) zur Bestimmung der aktuellen Position eines Fahrzeugs (1) verbunden ist, und die Messeinrichtung (7) wenigstens eine Stromquelle (12), die zur Erzeugung eines in den Fahrdraht (4) einspeisbaren Messstroms ($I_{Mess}$) ausgebildet ist, und wenigstens eine Spannungsmesseinrichtung (14), die zur Ermittlung eines Spannungsabfalls in dem Abschnitt (22) des Fahrdrahtes (4) ausgebildet ist, und wenigstens eine Speichereinheit (16), die zur Ablegung der Messwerte der Spannungsmesseinrichtung (14) mit der durch die Positionsbestimmungseinrichtung (8) ermittelten, aktuellen Position des Fahrzeugs (1) ausgebildet ist, aufweist.

11. Messeinrichtung (7) nach Anspruch 10,
**dadurch gekennzeichnet, dass**
die Messeinrichtung (7) potentialgetrennt zur Fahrleitung (4) ausgebildet ist.

12. Fahrzeug (1) mit einem Kontaktmittel (6) zum Kontaktieren eines Fahrdrahtes (4) einer verkehrstechnischen Anlage (2), wobei das Fahrzeug (1) zum Fahren auf einem entlang des Fahrdrahtes (4) verlaufenden Fahrweges (5) ausgebildet ist,
**dadurch gekennzeichnet, dass**
das Fahrzeug (1) wenigstens eine Messeinrichtung (7) nach einem der Ansprüche 10 bis 11 aufweist, die mit dem Kontaktmittel (6) verbunden ist.

13. Fahrzeug (1) nach Anspruch 12,
**dadurch gekennzeichnet, dass**
das Fahrzeug (1) wenigstens eine Erkennungseinrichtung (11) zur Erkennung von widerstandsverändernden Konstruktionselementen (20) an der Fahrleitung (4) ausgebildet ist.

**Claims**

1. Method for determining contact wire wear in a traffic system (2),
in which an actual cross-section of the contact wire (4) which is representative of the wear is determined, wherein, in order to ascertain the actual cross-section in a section of the contact wire (4), an actual resistance in the section (22) is determined,
**characterised in that**
the position of the section (22) of the contact wire (4) is detected and the wear at a plurality of positions of the traffic system (2) is determined, stored and the area-wide wear of the contact wire (4) is shown graphically in the traffic system.

2. Method according to claim 1,
**characterised in that**
the actual resistance is compared with a predetermined target resistance, in particular in a temperature-corrected manner.

3. Method according to claim 1 or 2,
**characterised in that**
the actual cross-section is compared with a predetermined target cross-section, in particular in a temperature-corrected manner.

4. Method according to claim 2 or 3,
**characterised in that**
the actual resistance or the actual cross-section is compared with a target resistance or target cross-section selected from a number of target resistances or target cross-sections as a function of the section (22) of the contact wire (4).

5. Method according to one of the afore-cited claims 2 to 4,
**characterised in that**
the target resistance, the target cross-section, the target resistances or the target cross-sections are determined in one or more reference measurements.

6. Method according to one of the afore-cited claims,
**characterised in that**
in order to determine the actual resistance, a measured current is introduced into the section of the contact wire (4) and a drop in voltage brought about as a result of the measuring current and the actual resistance is determined in section (22) of the contact wire (4).

7. Method according to one of the afore-cited claims,
**characterised in that**
the actual resistance is determined with galvanic isolation with respect to the contact wire (4).

8. Method according to one of the afore-cited claims,
**characterised in that**
the wear for the same section of the contact wire (4) is determined at various points in time and a wear of the section in the future is predicted therefrom.

9. Method according to one of the afore-cited claims, **characterised in that** the actual resistance is determined during a journey along the contact wire (4).

10. Measuring device (7) for determining contact wire wear in a traffic system (2), wherein the measuring device (7) is embodied to determine an actual cross-section of the contact wire (4) which is representative of the wear, wherein the measuring device (7) is embodied to determine the representative actual cross-section of the contact wire (4) in order to determine an actual resistance of a section of the contact wire (4), **characterised in that** the measuring device (7) is connected to a position determination device (8) in order to determine the current position of a vehicle (7), and the measuring device (7) has at least one current source (12) which is embodied to generate a measuring current ($I_{meas}$) which can be fed into the contact wire (4), and at least one voltage measuring device (14), which is embodied to determine a drop in voltage in the section (22) of the contact wire (4), and at least one storage unit (16), which is embodied to store the measured values of the voltage measuring device (14) with the current position of the vehicle (1) determined by the position determination device (8).

11. Measuring device (7) according to claim 10, **characterised in that** the measuring device (7) is embodied with galvanic isolation with respect to the contact wire (4).

12. Vehicle (1) with a contact means (6) for contacting a contact wire (4) of a traffic system (2), wherein the vehicle (1) is embodied for movement on a route (5) running along the contact wire (4), **characterised in that** the vehicle (1) has at least one measuring device (7) according to one of claims 10 to 11, which is connected to the contact means (6).

13. Vehicle (1) according to claim 12, **characterised in that** the vehicle (1) is embodied at least one identification device (11) for identifying resistance-changing construction elements (20) on the contact wire (4).

## Revendications

1. Procédé de détermination de l'usure d'une caténaire dans une installation (2) de la technique des transports, dans lequel on détermine une section transversale réelle, représentative de l'usure, de la caténaire (4), en définissant, pour la détermination de la section transversale réelle d'un tronçon de la caténaire (4), une résistance réelle du tronçon (22), **caractérisé en ce que** on relève la position du tronçon (22) de la caténaire (4) et on détermine l'usure en une pluralité de positions de l'installation (2) de la technique des transports, on la met en mémoire et l'on représente graphiquement l'usure, recouvrant en surface, de la caténaire (4) dans l'installation de la technique des transports.

2. Procédé suivant la revendication 1, **caractérisé en ce que** l'on compare la résistance réelle, notamment corrigée en température, à une résistance de consigne définie à l'avance.

3. Procédé suivant la revendication 1 ou 2, **caractérisé en ce que** l'on compare la section transversale réelle, notamment corrigée en température, à une section transversale de consigne définie à l'avance.

4. Procédé suivant la revendication 2 ou 3, **caractérisé en ce que** l'on compare la résistance réelle ou la section transversale réelle à une résistance de consigne ou à une section transversale de consigne, choisie parmi plusieurs résistances de consigne ou sections transversales de consigne en fonction du tronçon (22) de la caténaire (4).

5. Procédé suivant l'une des revendications 2 à 4 mentionnées ci-dessus, **caractérisé en ce que** l'on détermine la résistance de consigne, la section transversale de consigne, les résistances de consigne ou les sections transversales de consigne par une ou plusieurs mesures de référence.

6. Procédé suivant l'une des revendications précédentes, **caractérisé en ce que**, pour la détermination de la résistance réelle, on envoie un courant de mesure dans le tronçon de la caténaire (4) et on détermine, dans le tronçon (22) de la caténaire, une chute de tension provoquée par le courant de mesure et la résistance réelle.

7. Procédé suivant l'une des revendications précédentes **caractérisé en ce qu'**on détermine la résistance réelle de manière séparée en potentiel par rapport à la caténaire (4).

8. Procédé suivant l'une des revendications précédentes, **caractérisé en ce qu'**on détermine l'usure pour le même tronçon de la caténaire (4) à des instants différents et on en pronostique une usure du tronçon à l'avenir.

9. Procédé suivant l'une des revendications précédentes **caractérisé en ce que** l'on détermine le long de la caténaire (4) la résistance réelle pendant une marche.

10. Dispositif (7) de mesure pour la détermination de l'usure d'une caténaire dans une installation (2) de la technique des transports, le dispositif (7) de mesure étant constitué pour la détermination d'une section transversale réelle, représentative de l'usure, de la caténaire (4), le dispositif (7) de mesure étant pour la détermination de la section transversale réelle représentative de la caténaire (4), constitué pour la détermination d'une résistance réelle d'un tronçon de la caténaire (4), **caractérisé en ce que** le dispositif (7) de mesure est relié à un dispositif (8) de définition de position pour la définition de la position en cours d'un véhicule (1) et le dispositif (7) de mesure a au moins une source (12) de courant, qui est constituée pour produire un courant ($I_{Mess}$) de mesure pouvant être injecté dans la caténaire (4) et au moins un dispositif (14) de mesure de la tension, qui est constitué pour la détermination d'une chute de tension dans le tronçon (22) de la caténaire (4), et au moins une unité (16) de mise en mémoire, qui est constituée pour archiver les valeurs de mesure du dispositif (14) de tension avec la position en cours du véhicule (1) déterminée par le dispositif (8) de définition de position.

11. Dispositif (7) de mesures suivant la revendication 10, **caractérisé en ce que** le dispositif (7) de mesure est constitué de manière séparée en potentiel de la caténaire (4).

12. Véhicule (1) ayant un moyen (6) de contact pour la mise en contact d'une caténaire (4) d'une installation (2) de la technique des transports, le véhicule (1) étant constitué pour rouler sur une voie (5) de roulement s'étendant le long de la caténaire (4), **caractérisé en ce que** le véhicule (1) a au moins un dispositif (7) de mesure suivant l'une des revendications 10 à 11, qui est relié au moyen (6) de contact.

13. Véhicule (1) suivant la revendication 12, **caractérisé en ce que** le véhicule a au moins un dispositif (11) de détection pour la détection d'éléments (20) de construction, modifiant la résistance, sur la caténaire (4).

FIG 1

EP 3 571 089 B1

FIG 2

11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- SU 685526 A1

**In der Beschreibung aufgeführte Nicht-Patentliteratur**

- **DEUTZER ; FIEBELKORN ; PIRKL ; WINKLER ; DEUTZER.** Neues System zur Messung des Fahrdrahtverschleißes. *Der Nahverkehr,* April 2013, 40-43

- Inspektion von Fahrdrahtlage und -stärke bei beliebiger Geschwindigkeit. *Sarnes, Elektrische Bahnen eb 99,* Dezember 2001, 490-495
- **RICHTER, SCHNEIDER.** Automatische optische Inspektion von Oberleitungen. *Elektrische Bahnen eb 99,* 01. Februar 2001, 90-100